# EUROPÄISCHE PATENTSCHRIFT

(11) **EP 0 892 991 B1**
(45) Veröffentlichungstag und Bekanntmachung des Hinweises auf die Patenterteilung: **16.08.2001**
(21) Anmeldenummer: 97918053.6
(22) Anmeldetag: 24.03.1997
(51) Int. Cl.: H01L 29/861, H01L 29/739, H01L 21/336

(54) **HALBLEITERBAUELEMENT MIT EINSTELLBARER, AUF EINEM TUNNELSTROMGESTEUERTEN LAWINENDURCHBRUCH BASIERENDE STROMVERSTÄRKUNG**
SEMICONDUCTOR COMPONENT WITH ADJUSTABLE CURRENT AMPLIFICATION BASED ON AVALANCHE BREAKDOWN CONTROLLED BY TUNNEL CURRENT
COMPOSANT A SEMI-CONDUCTEUR A AMPLIFICATION DE COURANT AJUSTABLE, FONDEE SUR UN CLAQUAGE PAR AVALANCHE COMMANDE PAR COURANT TUNNEL

(30) Priorität: 09.04.1996 DE 19614010
(43) Veröffentlichungstag der Anmeldung: 27.01.1999
(73) Patentinhaber: Infineon Technologies AG, 81669 München (DE)
(72) Erfinder: KAKOSCHKE, Ronald, D-81475 München (DE)
(74) Vertreter: Zedlitz, Peter, Dipl.-Inf.
(86) Internationale Anmeldenummer: DE9700595
(87) Internationale Veröffentlichungsnummer: WO9738448

(56) Entgegenhaltungen:
- DE-A- 1 803 035
- DE-A- 4 413 822
- US-A- 4 953 928
- US-A- 4 969 019

## Beschreibung

Die Erfindung betrifft ein Halbleiterbauelement mit einem ersten dotierten Gebiet eines ersten Leitungstyps, welches in einem Halbleitersubstrat des zweiten Leitungstyps angeordnet ist, und mit einem Kanalgebiet im Halbleitersubstrat, das benachbart zum ersten dotierten Gebiet angeordnet ist.

Die US-A-4,969,019 beschreibt eine Halbleitervorrichtung zum Erzeugen eines Tunnelstroms ohne einen verarmten PN-Übergang. Ein stark dotierter P-Typ-Halbleiterbereich ist in einem leicht dotierten P-Typ-Halbleitersubstrat gebildet und beabstandet von einem stark dotierten N-Typ-Halbleiterbereich, wobei ein Leitungskanal dazwischen ausgebildet ist. Ein dünner elektrischer Isolator ist über dem P-Typ-Halbleiterbereich und dem Leitungskanal gebildet. Ein Gateanschluß ist über dem dünnen Isolator gebildet. Verbindungen mit der Halbleitervorrichtung sind vorgesehen durch einen Substratanschluß, der mit dem Substrat verbunden ist, einen Gateanschluß, der mit dem Gate verbunden ist, und einen Trennanschluß, der mit dem N-Typ-Halbleiterbereich verbunden ist. Eine an den Gateanschluß angelegte Spannung bewirkt eine Bandverbiegung in P-Typ-Halbleiterbereich, welche größer als die Bandlücke ist, um so ein Tunneln von Elektronen vom Valenzband ins Leitungsband zu bewirken. Eine Inversion des P-Typ-Halbleiterbereichs ist durch eine Trennspannung verhinderbar, welche an den n-Typ-Halbleiterbereich angelegt wird und Leitungselektronen anzieht.

Die DE-OS 1803035 beschreibt ein Feldeffekt-Halbleiterbauelement mit einem Halbleiterkörper eines vorgegebenen Leitungstyps, der eine Anordnung enthält, deren elektrische Eigenschaften durch elektrische Ladungen steuerbar ist, die sich in der Nähe der Oberfläche des Körpers und außerhalb von diesem befinden, ferner mit einem auf der Oberfläche angeordneten Isolierkörper und einer Anordnung zum Erzeugen eines elektrischen Feldes im Isolierkörper. Der Isolierkörper weist zwei Schichten auf, von denen die erste eine Dicke hat, die kleiner als die für Ladungsträger aus dem Halbleiterkörper unter dem Einfluß einer vorgegebenen Feldstärke in der ersten Schicht durchtunnelbare Strecke ist. Die zweite Schicht weist Mittel zum einschließen von Ladungsträgern in dieser Schicht auf.

Bei integrierten Halbleiterschaltungen werden zur Stromverstärkung meist Bipolar-Transistoren eingesetzt. Da diese mehrere dotierte Gebiete mit jeweils eigenem Anschluß aufweisen, ist der Platzbedarf relativ hoch.

Aufgabe der Erfindung ist die Angabe eines Halbleiterbauelements, welches bei geringem Platzbedarf eine sehr hohe Stromverstärkung gestattet. Diese Aufgabe wird durch das in Patentanspruch 1 angegebene Halbleiterbauelement gelöst. Vorteilhafte Weiterbildungen sind Gegenstand von Unteransprüchen.

Bei der Erfindung, welche in Anspruch 1 bzw. 11 definiert ist, handelt es sich um ein Halbleiterbauelement, das auf einem tunnelstromgesteuerten Lawinendurchbruch basiert. Das Bauelement weist ein erstes dotiertes Gebiet eines ersten Leitungstyps in einem Halbleitersubstrat eines zweiten Leitungstyps auf. Ein zum ersten dotierten Gebiet benachbartes Gebiet im Halbleitersubstrat stellt ein Kanalgebiet dar. Das erste dotierte Gebiet ist teilweise von einem dünnen Tunneldielektrikum bedeckt, das Kanalgebiet sowie ein vorbestimmter Randbereich des ersten dotierten Gebietes, der an das Kanalgebiet angrenzt, sind von einem Gatedielektrikum bedeckt. Auf dem Tunneldielektrikum ist eine Tunnelgateelektrode und auf dem Gatedielektrikum ist eine Kanalgateelektrode angeordnet. Die Kanalgateelektrode überlappt also den vorbestimmten Randbereich des ersten dotierten Gebietes. Sowohl das erste dotierte Gebiet als auch das Kanalgebiet sind anschließbar.

In einer bevorzugten Ausführungsform besteht das Halbleitersubstrat aus p-leitendem Silizium und besitzt ein p+-dotiertes Gebiet als Anschluß für das Kanalgebiet. Das erste dotierte Gebiet ist n-dotiert und über ein weiteres n+-dotiertes Gebiet anschließbar.

Im allgemeinen ist das Gatedielektrikum dicker als das Tunneldielektrikum. Soll ein Bauelement mit besonders hoher Stromverstärkung hergestellt werden, können beide Dielektrika dieselbe Dicke besitzen. Bei der Ausführungsform mit einer gemeinsamen Gateelektrode kann dies dazu führen , daß eine Potentialbarriere, wie sie unten näher erläutert wird, nicht auftritt.

Die Tunnelgateelektrode und die Kanalgateelektrode können leitend miteinander verbunden sein und eine gemeinsame Gateelektrode bilden, die aus der selben leitenden Schicht hergestellt werden kann. Das gemeinsame Gate kann von außen an eine Spannung U_{G} anschließbar sein, es kann aber auch ein sogenanntes Floating-Gate ähnlich wie das eines EPROMs sein. Im letzten Fall ist vorzugsweise ein Steuergate über dem gemeinsamen Gate vorgesehen. Sind die Tunnelgateelektrode und die Kanalgateelektrode gegeneinander isoliert, können sie mit verschiedenen Potentialen verbunden werden.

Das Bauelement kann einfach hergestellt werden und besitzt einen geringen Platzbedarf. Besonders vorteilhaft ist eine selbstjustierte Herstellung des Tunneldielektrikums zum ersten dotierten Gebiet, da dadurch die elektrischen Eigenschaften des Bauelementes genauer eingestellt werden können und der Platzbedarf erniedrigt wird.

Im folgenden wird die Erfindung und ihre elektrische Funktionsweise anhand von Ausführungsbeispielen näher erläutert, welche in den Zeichnungen dargestellt sind. Es zeigen:
- Figur 1: einen Querschnitt durch ein Halbleitersubstrat mit dem Bauelement,
- Figuren 2 bis 4: den Potentialverlauf entlang vorgegebener Achsen im Bauelement,
- Figuren 5a, 5b: den Tunnelstrom und den verstärkten Drainstrom bei verschiedenen Spannungen am Gate
- Figuren 6 bis 8: einen Querschnitt durch das Halbleitersubstrat, an dem die wesentlichen Schritte des Herstellverfahrens verdeutlicht werden,
- Figuren 9 bis 11: weitere Ausführungsformen des Halbleiterbauelementes.

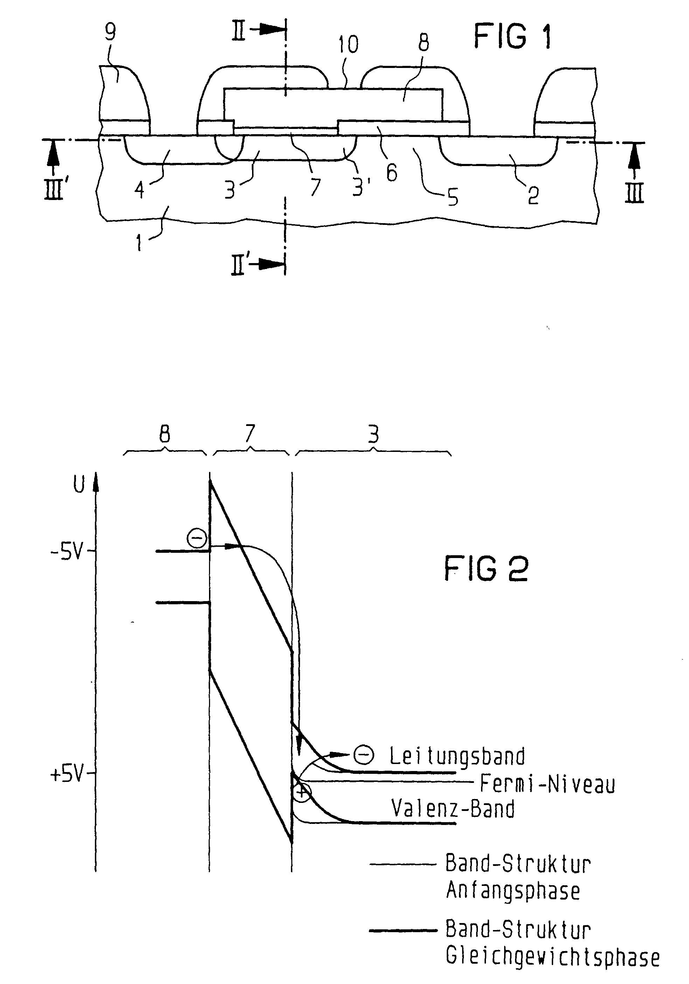

Figur 1: In einem Halbleitersubstrat 1 eines zweiten Leitungstyps mit einem hochdotierten Anschluß 2 des zweiten Leitungstyps befindet sich ein erstes dotiertes Gebiet 3 des ersten Leitungstyps mit einem hochdotierten Anschluß 4 des ersten Leitungstyps. Die Oberfläche des Halbleitersubstrats 1 bildet gleichzeitig jeweils eine Oberfläche der dotierten Gebiete 2, 3, 4. Das zum ersten dotierten Gebiet 3 benachbarte Substratgebiet 5 stellt ein Kanalgebiet 5 dar, es liegt zwischen dem hochdotierten Anschlußgebiet 2 und dem ersten dotierten Gebiet 3. Auf der Halbleitersubstratoberfläche befindet sich ein Gatedielektrikum 6, das das Kanalgebiet 5 und den dem Kanalgebiet zugewandten Randbereich 3' des ersten dotierten Gebietes 3 bedeckt. Der überwiegende Teil des ersten dotierten Gebietes ist mit einem Tunneldielektrikum 7 bedeckt, das dünner als das Gatedielektrikum ist. Der mit dem Tunneldielektrikum bedeckte Bereich des ersten dotierten Gebietes 3 wird als Tunnelfenster bezeichnet. Tunneldielektrikum 7 und Gatedielektrikum 6 sind in diesem Beispiel mit einer gemeinsamen Gateelektrode 8 bedeckt. Die Anordnung ist mit einer Isolierung 9 bedeckt, die Öffnungen für die Anschlüsse 2, 4 und 10 (für Halbleitersubstrat, erstes dotiertes Gebiet und Gate) aufweist.

Es wird nun der Fall betrachtet, bei dem das Anschlußgebiet 4 an der Seite des Tunnelfensters n+-dotiert und das Anschlußgebiet 2 an der Seite des Gatedielektrikums p+-dotiert ist. Das Tunnelfenster ist durch das n-dotierte Gebiet 3 angeschlossen, das über die Tunnelfensterberandung hinausreicht. Das Kanalgebiet 5 unter dem Gatedielektrikum 6 ist entsprechend der Substratdotierung schwach p-dotiert. Es ist über das hochdotierte p+-Gebiet 2 an der Gatedielektrikumseite des gemeinsamen Gates 8 angeschlossen. Es wird folgende Beschaltung durchgeführt:
U_{G} = 0 bis -5 V am Anschluß 10
U₁ = +5 V am Anschluß 4
U_{S} = 0 V am Anschluß 2.
Das gemeinsame Gate 8 liegt relativ zum n-dotierten ersten Gebiet auf negativem Potential.

Figur 2 stellt den Potentialverlauf entlang der in Figur 1 mit II-II' bezeichneten Achse in einer ersten Näherung dar. Ist die Potentialdifferenz zwischen dem gemeinsamen Gate 8 und dem ersten dotierten Gebiet 3 ausreichend groß, können Elektronen - aus dem Gate durch die Potentialbarriere im Tunneldielektrikum 7 in das Leitungsband des Tunneldielektrikums tunneln und dann in das erste dotierte Gebiet 3 gelangen (die dünne Linie des Bänderdiagramms in Figur 2 stellt dabei den ursprünglichen Potentialverlauf dar). Dabei nehmen sie genug Energie auf, um im ersten dotierten Gebiet 3 Elektron-Lochpaare - - + zu erzeugen. Die Löcher, die sich an der Grenzfläche zum Tunneldielektrikum anreichern, verbiegen die Bänder, bis ein Quasi-Gleichgewichtszustand erreicht wird (dieser wird durch die dicke Linie dargestellt; Löcher haben die Tendenz, an der Oberkante des Valenzbandes entlang zu dem für sie tieferen Potential zu laufen). Der Strom vom gemeinsamen Gate zum ersten dotierten Gebiet wird durch den Tunnelvorgang bestimmt. Der Strom vom Gebiet 3 zum Substrat, insbesondere zum Kanalgebiet 5, kann vernachlässigt werden, wenn als erste Näherung der Rand des Tunneldielektrikums (Berandung des Tunnelfensters) nicht berücksichtigt werden muß, d.h. wenn eine eindimensionale Betrachtung entlang einer Koordinatenachse senkrecht zur Grenzfläche ausreichend ist.

Bei einem realen Bauelement muß die Berandung des Tunneldielektrikums berücksichtigt werden. Bei der Beschreibung des Tunnelvorgangs wird eine zweidimensionale Betrachtung notwendig. Dazu wird der Potentialverlauf in der Nähe der Substratoberfläche entlang einer horizontalen Achse betrachtet.

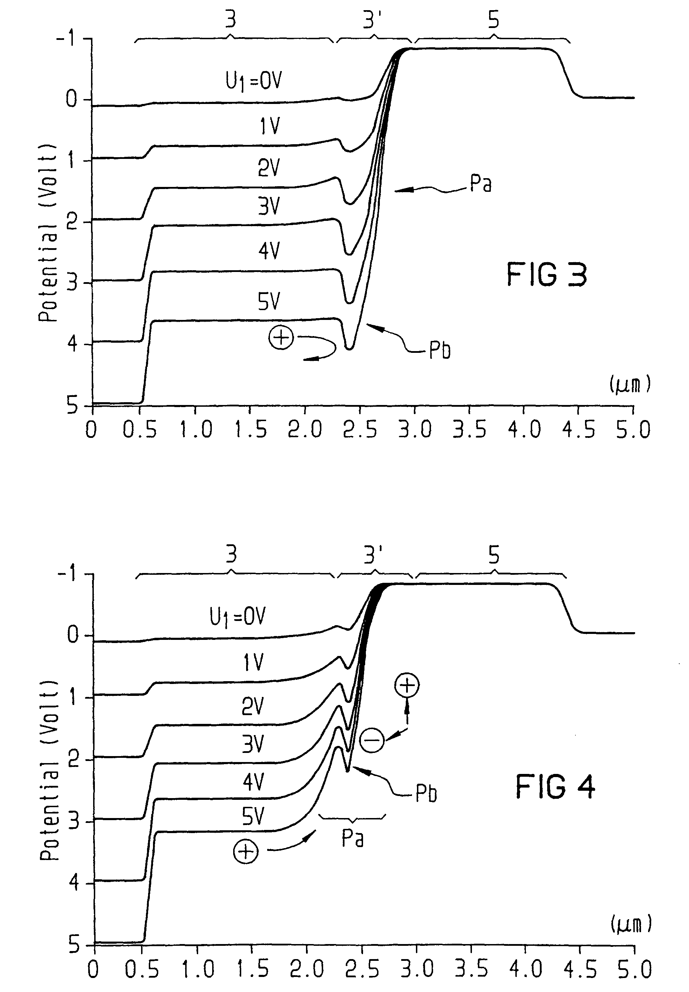

Figur 3 stellt den Potentialverlauf bei verschiedenen Werten von U₁ entlang der Grenzfläche senkrecht zur Zeichenebene der Figur 2 dar, also entlang der in Figur 1 mit III-III' bezeichneten Achse in einer Simulationsrechnung dar. Da bei der folgenden Beschreibung Löcher die entscheidende Rolle spielen, bezieht sich der Begriff "Potential" jeweils auf ein Potential für Löcher (d.h. das Potential nimmt von positiven zu negativen Spannungswerten ab). Dabei ist der Fall eines großen Randbereichs des ersten dotierten Gebietes gezeigt. Der Randbereich 3' ist definitionsgemäß der Teil des ersten dotierten Gebietes 3, der an das Kanalgebiet 5 anschließt und vom Gatedielektrikum 6 bedeckt ist. Der pn-Übergang zwischen dem ersten dotierten Gebiet 3 (n-dotiert) und dem Kanalgebiet 5 bzw. Substrat (p-dotiert) ist in Sperrichtung gepolt. Dies führt zu einem starken Potentialgefälle. Am Übergang des Tunneldielektrikums zum Gatedielektrikum bildet sich bei U₁ > 0 sowohl im Leitungs- als auch im Valenzband noch eine kleine Potentialbarriere Pb für Löcher aus, da das Potential an der Grenzfläche von der Oxiddicke abhängt. Das Potential im ersten dotierten Gebiet 3 unter dem Tunneldielektrikum 7 ist bei gleicher Dotierkonzentration für Löcher tiefer als unter dem Gatedielektrikum. Der Potentialabfall Pa zum p-Gebiet setzt erst mit dem Konzentrationsabfall der Dotierung ein. Löcher + , die durch die Injektion hochenergetischer Elektronen durch das Tunneldielektrikum im ersten dotierten Gebiet erzeugt werden, können somit das erste dotierte Gebiet nicht verlassen, sondern werden an der Potentialbarriere reflektiert. Zur Beschreibung des Tunnelvorgangs reicht die bereits zur Figur 2 durchgeführte Betrachtung aus.

In Figur 4 ist der der Figur 3 entsprechende Potentialverlauf im Fall eines kleinen Randbereichs 3' gezeigt. Der Potentialabfall Pa zum p-Gebiet setzt früher ein. Die Potentialbarriere Pb fällt in den abfallenden Ast und liegt damit unter dem Potential im ersten dotierten Gebiet. Die durch Tunnelelektronen erzeugten Löcher können -im Gegensatz zur Situation in Figur 3- aus dem ersten dotierten Gebiet 3 entweichen und das Potentialgefälle zum Kanalgebiet hin durchlaufen. Dabei werden durch Stoßionisation weitere Elektron-Lochpaare - - + erzeugt. Es kommt zu einer Ladungsmultiplikation, so daß der Strom vom ersten dotierten Gebiet 3 zum Kanalgebiet 5 um viele Größenordnungen (etwa 10⁴ bis 10⁶) über dem Tunnelstrom liegt. Entsprechend wird der Quasi-Gleichgewichtszustand nie erreicht, da die Löcher + lateral entkommen und somit nicht zu einer Bandverbiegung führen. Der Verstärkungsfaktor kann durch das Dickenverhältnis Tunneldielektrikum zu Gatedielektrikum (Beeinflussung der Potentialbarriere), die Dotierungen im ersten dotierten Gebiet und im Kanalgebiet und durch den Überlapp des Gatedielektrikums über das erste dotierte Gebiet, d.h. durch die Größe des Randbereichs 3', eingestellt werden. Bspw. führt ein dickeres Gatedielektrikum zu einer Erhöhung der Potentialbarriere Pb. Eine hohe Dotierung des ersten Gebietes verstärkt einerseits die laterale Ausdiffusion und erniedrigt andererseits die Potentialbarriere Pb.

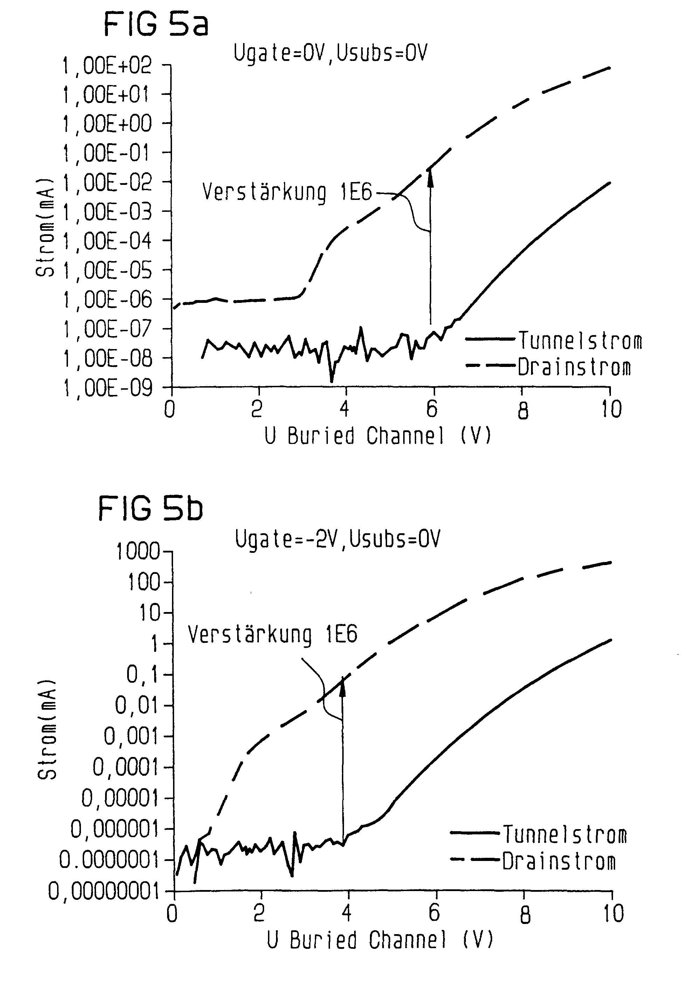

Figur 5 zeigt als Maßergebnis den sogenannten Drain-Strom zwischen den Anschlüssen 2 und 4, also zwischen dem ersten dotierten Gebiet und dem Substrat, und den Tunnelstrom zwischen den Anschlüssen 10 und 4 in Abhängigkeit vom Potential am Anschluß 4. Dabei ist in Fig. 5a U_{G}= 0V, U_{S} = 0V bzw. in Fig. 5b U_{G} = -2V, U_{S} = 0V gewählt. Man erkennt, daß der Lawinendurchbruch bei ca. 6V bzw. ca. 4V einsetzt und der Verstärkungsfaktor zwischen Tunnelstrom und Drainstrom 10⁶ bis 10⁴ beträgt.

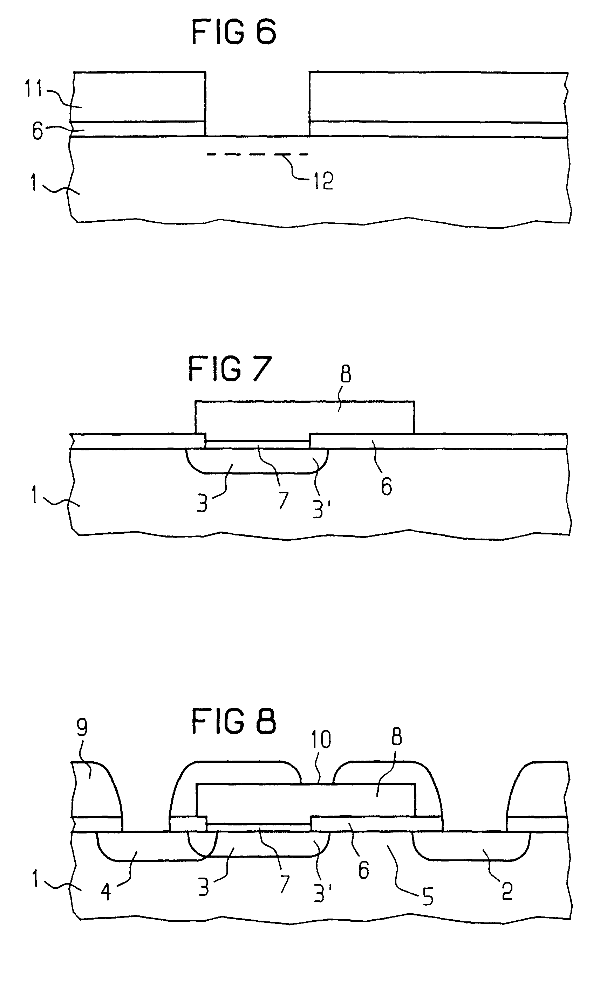

Figur 6: Das in Figur 1 dargestellte Bauelement kann auf einfache Weise hergestellt werden. Dazu wird auf einem p-dotierten Silizium-Substrat 1 ganzflächig ein Gatedielektrikum 6 nach bekannten Verfahren aufgebracht, bspw. ein Siliziumoxid von 25 nm Dicke. Darüber wird eine Fotomaske 11 erzeugt, die an der Stelle des zu erzeugenden ersten dotierten Gebietes eine Öffnung aufweist. Durch diese Öffnung werden nun Phosphorionen 12 in das Substrat implantiert, das Gatedielektrikum dient dabei als Streuoxid. Anschließend wird vorzugsweise unter Verwendung derselben Fotomaske 11 das Gatedielektrikum strukturiert, so daß es über dem implantierten Gebiet eine Öffnung besitzt. Die Kante des Gatedielektrikums 6 und das erste dotierte Gebiet sind dann selbstjustiert zueinander und die Größe des Randbereichs 3', welche die elektrischen Eigenschaften bestimmt, kann nachfolgend genau eingestellt werden.

Figur 7: Die Maske 11 wird abgelöst, und auf der freiliegenden Substratoberfläche wird ein dünnes Tunneldielektrikum 7 erzeugt. Dafür wird in einem RTP-Verfahren (Rapid Thermal Anneal) ein nitridiertes Oxid von etwa 8 nm Dicke aufgewachsen, durch die dabei auftretenden Temperaturen von 1000 bis 1150°C wird gleichzeitig die vorhergehende Implantation ausgeheilt. Die dabei stattfindende Ausdiffusion im Substrat hat zur Folge, daß das erste dotierte Gebiet 3 sich über die Tunnelfensterberandung hinaus bis unter das Gatedielektrikum 6 erstreckt. Durch geeignete Wahl der Parameter kann dabei ein vorbestimmter Randbereich 3', der unter dem Gatedielektrikum liegt; eingestellt werden. Das RTP-Verfahren ist der wesentliche Schritt, der aufgrund seiner thermischen Belastung für das Substrat die Größe des ersten dotierten Gebietes 3 bestimmt. Anschließend wird eine Polysiliziumschicht ganzflächig aufgebracht und zur gemeinsamen Gateelektrode 8 strukturiert. Diese Gateelektrode 8 bedeckt das Tunnelfenster sowie einen daran anschließenden Bereich des Gatedielektrikums 6.

Figur 8: Anschließend wird nach üblichem Verfahren die Gateelektrode mit einer Isolierschicht 9 versehen, die die Gateelektrode allseits bedeckt. Diese Isolierschicht 9 weist Öffnungen über den Anschlüssen 2, 4 und 10 auf.

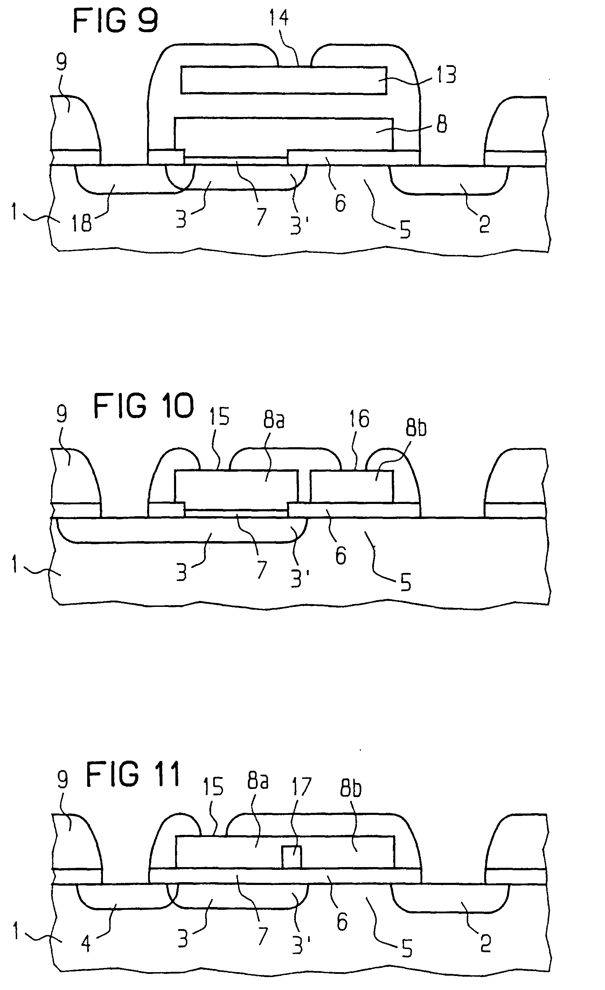

Figur 9: Das Bauelement kann als Bestandteil einer EEPROM-Zelle eingesetzt werden. Das gemeinsame Gate 8 ist in diesem Fall isoliert (Floating-Gate), darüber ist ein Steuergate 13 angeordnet. Das Steuergate besitzt einen Anschluß 14.

Eine solche Anordnung kann als Analogspeicher bzw. als Analog-Digital-Wandler eingesetzt werden. Es wird z.B. ein Analogsignal gespeichert, in dem an das Steuergate 13 über seinen Anschluß 14 eine dem Signal proportionale Spannung U_{SG} angelegt wird (dabei ist U₁ = 0 V, U_{S} = 0 V). Die aus dem ersten dotierten Gebiet 3 in das Floating-Gate 8 tunnelnde Ladung wird permanent gespeichert. Sie ist ein Maß für die angelegte Spannung. Beim Auslesen wird U₁ am Anschluß 4 auf etwa 8 V gelegt (U_{S} = 0 V, U_{SG} = 0 V). Elektronen tunneln aus dem Floating-Gate 8 in das erste dotierte Gebiet 3 und setzen die Ladungsmultiplikation in Gang, die erst abbricht, wenn keine Elektronen mehr aus dem Gate 8 tunneln. Die so verstärkte Ladungsmenge kann leicht gemessen werden.

Für den Einsatz als Bestandteil einer EEPROM-Zelle wird das erste dotierte Gebiet 3 durch die Tunnelfenstermaske 11 implantiert. Dosis und Temperaturbudget beim RTP-Verfahren werden so gewählt, daß diese Dotierung soweit über das Tunnelfenster hinausdiffundiert (d.h. soweit unter das Gatedielektrikum), daß der Verstärkungsfaktor kleiner als 10 wird. Zum Programmieren wird U₁ = 15 V am Anschluß 4 angelegt, so daß Elektronen aus dem Floating-Gate 8 tunneln (dabei ist U_{S} = 0, U_{SG} = 0. Die Ladungsmultiplikation ist so gering, daß selbst eine schwach dimensionierte Ladungspumpe die Programmierspannung aufrechterhalten kann.

Figur 10: In dieser Ausführungsform sind die Tunnelgateelektrode 8a und die Kanalgatelektrode 8b von einander isoliert. Beide Elektroden können jeweils einen Anschuß 15, 16 besitzen und an verschiedene Potentiale angelegt werden. Auf die hochdotierten Anschlußgebiete 2, 4 wurde verzichtet, statt dessen ist das erste Gebiet 3 so dimensioniert, daß es von außen anschließbar ist. Dies kann bspw. dadurch erreicht werden, daß die Implantation für das erste dotierte Gebiet und das Ätzen des Gatedielektrikum mit verschiedenen Masken erfolgt. Die Isolierung der beiden Gate-Elektroden voneinander kann bspw. mit Hilfe eines Spacers erfolgen. Die beiden Gate-Elektroden können aus der gleichen oder aus verschiedenen leitenden Schichten hergestellt werden.

Der Vorteil dieser Anordnung liegt in der Möglichkeit, durch Variation der Spannungen an den Anschlüssen 8a und 8b die Potentialbarriere zu beeinflussen und somit den Verstärkungsfaktor gezielt nur über die Gatepotentiale einzustellen.

Fig 11: Die Isolation 17 zwischen der Tunnelgateelektrode 8a und der Kanalgateelektrode 8b bewirkt eine Potentialbarriere. Damit können das Gate- und das Tunneldielektikum gleich dick hergestellt werden, ohne daß auf die Potentialbarriere verzichtet werden muß. Die Isolation 17 stellt quasi eine lokale Erhöhung der Gateoxiddicke dar. Eine solche Anordnung mit gleich dickem Gate- und Tunneldielektikum ist in der Figur dargestellt, dabei sind Gate- und Tunneldielektikum an ihrer Oberkante kurzgeschlossen. Eine solche Anordnung kann wie vorher beschrieben, bspw. bei EEPROMs, eingesetzt werden. Die Höhe und Lage der Barriere Pb wird über die Dimensionierung der Isolation 17 und von Gate- und Tunneldielektikum eingestellt.

## Patentansprüche

1. Halbleiterbauelement mit:
- einem ersten dotierten Gebiet (3) eines ersten Leistungstyps, welches in einem Halbleitersubstrat (1) des zweiten Leitungstyps angeordnet ist und einen Anschluß aufweist,
- einem Kanalgebiet (5) des zweiten Leistungstyps im Halbleitersubstrat, welches benachbart zum ersten dotierten Gebiet (3) angeordnet ist und einen Anschluß aufweist,
- einem Tunneldielektrikum (7), welches eine Oberfläche des ersten dotierten Gebietes (3) teilweise bedeckt,
- einem Gatedielektrikum (6), welches eine Oberfläche des Kanalgebietes (5) sowie einen vorbestimmten Randbereich (3') des ersten dotierten Gebietes bedeckt,
- einer auf dem Randbereich (3') angeordneten Isolationsschicht (6, 17), die ganz oder teilweise vom Gatedielektrikum (6) gebildet wird und eine größere Schichtdicke als das Tunneldielektrikum (7) aufweist,
- einer Tunnelgateelektrode (8a) auf dem Tunneldielektrikum, und
- einer Kanalgateelektrode (8b) auf dem Gatedielektrikum, bei dem das erste dotierte Gebiet (3) an ein Potential U₁ und das Kanalgebiet (5) an ein Potential Us anschließbar sind, so daß zwischen diesen Anschlüssen ein gegenüber einem durch das Tunneldielektrikum fließenden Strom dadurch verstärkter Strom fließt, daß bei in Sperrrichtung gepoltem pn-Übergang zwischen dem ersten dotierten Gebiet (3) und dem Kanalgebiet (5) die Potentialbarriere (Pb) für die Majoritätsträger (+) des zweiten Leitungstyps am Übergang des Tunneldielektrikums (7) zum Gatedielektrikum (6) in den abfallenden Ast der Potentialbarriere (Pa) zwischen dem ersten dotierten Gebiet (3) und dem Kanalgebiet (5) fällt und damit unter dem Potential der Majoritätsträger im ersten dotierten Gebiet liegt, wobei der Verstärkungsfaktor durch einen der folgenden Parameter: Dicke des Tunneldielektrikum (7), Dicke des Gatedielektrikum (6), Dicke der Isolationsschicht (6, 17), Dotierkonzentration des ersten dotierten Gebietes (3) oder des Kanalgebietes (5), Größe des Randbereichs (3'), einstellbar ist.

2. Halbleiterbauelement nach Anspruch 1,
bei dem das Gatedielektrikum (6) dicker als das Tunneldielektrikum (7) ist.

3. Halbleiterbauelement nach einem der Ansprüche 1 bis 2, bei dem die Tunnelgateelektrode (8a) und/oder die Kanalgateelektrode (8b) einen Gateanschluß (10, 15, 16) besitzen

4. Halbleiterbauelement nach einem der Ansprüche 1 bis 3, bei dem die Tunnelgateelektrode (8a) und die Kanalgateelektrode (8b) leitend miteinander verbunden sind als gemeinsame Gateelektrode (8).

5. Halbleiterbauelement nach einem der Ansprüche 1 bis 4,
bei dem der erste Leitungstyp der n-Leitungstyp und der zweite Leitungstyp der p-Leitungstyp ist.

6. Halbleiterbauelement nach Anspruch 5,
bei dem an das erste dotierte Gebiet (3) ein positives Potential (U₁ > 0) angelegt wird, an das gemeinsame Gate (8) über den Gateanschluß (10) ein nicht positives Potential (U_{G} ≤ 0), und an das Halbleitersubstrat ein Massepotential angelegt wird (U_{S} = 0 V).

7. Halbleiterbauelement nach einem der Ansprüche 1 bis 6,
bei dem die Parameter: Dicke des Tunneldielektrikums (7), Dicke des Gatedielektrikums (6), Größe des vorbestimmten Randbereichs (3') des ersten dotierten Gebietes so gewählt sind, daß bei vorgegebenen Potentialen U_{S}, U_{G} oder U_{S}, U_{G}, U₁ die durch das Tunneldielektrikum tunnelnden Elektronen einen Lawinendurchbruch zum Kanalgebiet (5) erzeugen.

8. Halbleiterbauelement nach einem der Ansprüche 1 bis 7,
bei dem über dem gemeinsamen Gate (8) und isoliert dazu ein Steuergate angeordnet ist.

9. Halbleiterbauelement nach einem der Ansprüche 1 bis 8,
bei dem der Anschluß des Kanalgebietes (5) über ein hochdotiertes Gebiet (2) des zweiten Leitungstyps im Halbleitersubstrat erfolgt.

10. Halbleiterbauelement nach einem der Ansprüche 1 bis 9, bei dem der Anschluß des ersten dotierten Gebietes (3) über ein hochdotiertes Gebiet des ersten Leitungstyps im Halbleitersubstrat erfolgt.

11. Herstellungsverfahren für ein Halbleiterbauelement nach einem der Ansprüche 1 bis 10 mit folgenden Schritten:
- Erzeugen eines Gatedielektrikums (6) auf einem Halbleitersubstrat (1) eines zweiten Leitungstyps;
- Aufbringen einer Fotomaske (11) auf dem Gatedielektrikum (6), welche im Bereich eines herzustellenden Tunneldielektrikums eine Öffnung aufweist;
- Herstellen eines ersten dotierten Gebietes (3) eines ersten Leitungstyps unterhalb der Öffnung durch eine Implantation durch das Gatedielektrikum hindurch;
- Entfernen des Gatedielektrikums (6) von der Oberfläche des ersten dotierten Gebietes (3) bis auf einen Randbereich (3') des ersten dotierten Gebietes;
- Entfernen der vorhandenen Fotomaske (11);
- thermisches Erzeugen eines Tunneldielektrikums (7) auf der freiliegenden Halbleitersubstratoberfläche und gleichzeitiges Ausdiffundieren des ersten dotierten Gebietes (3) unter das Gatedielektrikum (6);
- Herstellen einer Tunnelgateelektrode (8a) auf dem Tunneldielektrikum (7) und einer Kanalgateelektrode (8b) auf einem vorgegebenen Teil des Gatedielektrikums (6);
- Herstellen eines Anschlusses für das Kanalgebiet (5) und eines Anschlusses für das Halbleitersubstrat (1).

12. Herstellverfahren nach Anspruch 11,
bei dem das Tumnneldielektrikum (7) dünner als das Gatedielektrikum (6) hergestellt wird.

13. Herstellverfahren nach einem der Ansprüche 11 bis 12,
bei dem bei der Entfernung des Gatedielektrikums auf dem ersten dotierten Gebiet (3) die übrige Substratoberfläche mit der bei der Implantation eingesetzten Fotomaske abgedeckt ist, so daß die Entfernung selbstjustiert zum ersten dotierten Gebiet (3) erfolgt.

## Claims

1. Semiconductor component having:
- a first doped region (3) of a first conduction type, which is arranged in a semiconductor substrate (1) of the second conduction type and has a connection,
- a channel region (5) of the second conduction type in the semiconductor substrate, which is arranged adjacent to the first doped region (3) and has a connection,
- a tunnel dielectric (7), which partly covers a surface of the first doped region (3),
- a gate dielectric (6), which covers a a surface of the channel region (5) and also a predetermined edge zone (3') of the first doped region,
- an insulation layer (6, 17), which is arranged on the edge zone (3'), is formed entirely or partly by the gate dielectric (6) and has a greater layer thickness than the tunnel dielectric (7),
- a tunnel gate electrode (8a) on the tunnel dielectric, and
- a channel gate electrode (8b) on the gate dielectric, in which the first doped region (3) can be connected to a potential U₁ and the channel region (5) can be connected to a potential U_{S}, with the result that there flows between these connections a current which, relative to a current flowing through the tunnel dielectric, is amplified by the fact that, in the case of a reverse-biased pn junction between the first doped region (3) and the channel region (5), the potential barrier (Pb) for the majority carriers (+) of the second conduction type at the junction between the tunnel dielectric (7) and the gate dielectric (6) falls into the falling branch of the potential barrier (Pa) between the first doped region (3) and the channel region (5) and thus lies below the potential of the majority carriers in the first doped region, the gain factor being adjustable by one of the following parameters: thickness of the tunnel dielectric (7), thickness of the gate dielectric (6), thickness of the insulation layer (6, 17), doping concentration of the first doped region (3) or of the channel region (5), size of the edge zone (3').

2. Semiconductor component according to Claim 1,
in which the gate dielectric (6) is thicker than the tunnel dielectric (7).

3. Semiconductor component according to one of Claims 1 to 2, in which the tunnel gate electrode (8a) and/or the channel gate electrode (8b) have a gate connection (10, 15, 16).

4. Semiconductor component according to one of Claims 1 to 3,
in which the tunnel gate electrode (8a) and the channel gate electrode (8b) are conductively connected to one another as a common gate electrode (8).

5. Semiconductor component according to one of Claims 1 to 4,
in which the first conduction type is the n conduction type and the second conduction type is the p conduction type.

6. Semiconductor component according to Claim 5,
in which a positive potential (U₁ > 0) is applied to the first doped region (3), a non-positive potential (U_{G} ≤ 0) is applied to the common gate (8) via the gate connection (10), and an earth potential is applied to the semiconductor substrate (U_{S} = 0 V).

7. Semiconductor component according to one of Claims 1 to 6,
in which the parameters: thickness of the tunnel dielectric (7), thickness of the gate dielectric (6), size of the predetermined edge zone (3') of the first. doped region are chosen in such a way that, in the case of predetermined potentials U_{S}, U_{G} or U_{S}, U_{G}, U₁, the electrons which tunnel through the tunnel dielectric produce an avalanche breakdown to the channel region (5).

8. Semiconductor component according to one of Claims 1 to 7,
in which a control gate is arranged above the common gate (8) and in a manner insulated therefrom.

9. Semiconductor component according to one of Claims 1 to 8,
in which the connection of the channel region (5) is effected via a highly doped region (2) of the second conduction type in the semiconductor substrate.

10. Semiconductor component according to one of Claims 1 to 9,
in which the connection of the first doped region (3) is effected via a highly doped region of the first conduction type in the semiconductor substrate.

11. Fabrication method for a semiconductor component according to one of Claims 1 to 10, having the following steps:
- production of a gate dielectric (6) on a semiconductor substrate (1) of a second conduction type;
- application of a photomask (11) on the gate dielectric (6), the said photomask having an opening in the region of a tunnel dielectric to be fabricated;
- fabrication of a first doped region (3) of a first conduction type below the opening by means of implantation through the gate dielectric;
- removal of the gate dielectric (6) from the surface of the first doped region (3) except for an edge zone (3') of the first doped region;
- removal of the photomask (11) that is present;
- thermal production of a tunnel dielectric (7). on the uncovered semiconductor substrate surface and simultaneous outdiffusion of the first doped region (3) under the gate dielectric (6);
- fabrication of a tunnel gate electrode (8a) on the tunnel dielectric (7) and a channel gate electrode (8b) on a predetermined part of the gate dielectric (6) ;
- fabrication of a connection for the channel region (5) and a connection for the semiconductor substrate (1).

12. Fabrication method according to Claim 11,
in which the tunnel dielectric (7) is made thinner than the gate dielectric (6).

13. Fabrication method according to one of Claims 11 to 12,
in which, during the removal of the gate dielectric on the first doped region (3), the rest of the substrate surface is covered with the photomask used during the implantation, with the result that the removal is effected in a self-aligned manner with respect to the first doped region (3).

## Revendications

1. Composant à semi-conducteur comprenant :
- une première zone dopée (3) d'un premier type de conduction, qui est située dans un substrat semi-conducteur (1) du second type de conduction et est pourvue d'une connexion,
- une zone de canal (5) du second type de conduction dans le substrat semi-conducteur, qui est contiguë à la première zone dopée (3) et est pourvue d'une connexion,
- un diélectrique de tunnel (7) qui couvre partiellement une surface de la première zone dopée (3),
- un diélectrique de grille (6) qui couvre une surface de la zone de canal (5) ainsi qu'une zone de bordure (3') prédéterminée de la première zone dopée,
- une couche d'isolation (6, 17) située sur la zone de bordure (3'), qui est formée, entièrement ou partiellement, par le diélectrique de grille (6) et a une épaisseur de couche supérieure au diélectrique de tunnel (7),
- une électrode de grille de tunnel (8a) sur le diélectrique de tunnel, et
- une électrode de grille de canal (8b) sur le diélectrique de grille, dans lequel la première zone dopée (3) peut être reliée à un potentiel U₁ et la zone de canal (5) peut être reliée à un potentiel U_{S}, de manière à ce que circule entre ces connexions un courant qui est amplifié, par ce moyen, par rapport à un courant circulant à travers le diélectrique de tunnel, à ce que, lorsque la jonction PN entre la première zone dopée (3) et la zone de canal (5) est polarisée dans le sens de blocage, la barrière de potentiel (Pb) pour les porteurs majoritaires (+) du second type de conduction tombe, au niveau de la jonction du diélectrique de tunnel (7) et du diélectrique de grille (6), dans la branche descendante de la barrière de potentiel (Pa) entre la première zone dopée (3) et la zone de canal (5), et se trouve ainsi sous le potentiel des porteurs majoritaires dans la première zone dopée, le facteur d'amplification pouvant être ajusté grâce à un des paramètres suivants : épaisseur du diélectrique de tunnel (7), épaisseur du diélectrique de grille (6), épaisseur de la couche d'isolation (6, 17), concentration de dopage de la première zone dopée (3) ou de la zone de canal (5), grandeur de la zone de bordure (3').

2. Composant à semi-conducteur selon la revendication 1,
dans lequel le diélectrique de grille (6) est plus épais que le diélectrique de tunnel (7).

3. Composant à semi-conducteur selon l'une des revendications 1 à 2,
dans lequel l'électrode de grille de tunnel (8a) et/ou l'électrode de grille de canal (8b) est/sont pourvue/s d'un contact de grille (10, 15, 16).

4. Composant à semi-conducteur selon l'une des revendications 1 à 3,
dans lequel l'électrode de grille de tunnel (8a) et l'électrode de grille de canal (8b) sont reliées l'une à l'autre de manière conductrice en tant qu'électrode de grille (8) commune.

5. Composant à semi-conducteur selon l'une des revendications 1 à 4,
dans lequel le premier type de conduction est le type de conduction N et le second type de conduction est le type de conduction P.

6. Composant à semi-conducteur selon la revendication 5, dans lequel un potentiel positif (U₁ > 0) est appliqué au niveau de la première zone dopée (3), un potentiel non positif (U_{G} ≤ 0) est appliqué à la grille commune (8) par le biais du contact de grille (10) et un potentiel de masse (U_{S} = 0 V) est appliqué au substrat semi-conducteur.

7. Composant à semi-conducteur selon l'une des revendications 1 à 6,
dans lequel les paramètres : épaisseur du diélectrique de tunnel (7), épaisseur du diélectrique de grille (6), grandeur de la zone de bordure (3') prédéterminée de la première zone dopée, sont choisis de manière à ce que, pour des potentiels prédéfinis U_{S}, U_{G} ou U_{S}, U_{G}, U₁, les électrons circulant par effet tunnel à travers le diélectrique de tunnel produisent un claquage par avalanche vers la zone de canal (5).

8. Composant à semi-conducteur selon l'une des revendications 1 à 7,
dans lequel une grille de commande est située sur la grille commune (8) dont elle est isolée.

9. Composant à semi-conducteur selon l'une des revendications 1 à 8,
dans lequel la connexion de la zone de canal (5) se fait par l'intermédiaire d'une zone fortement dopée (2) du second type de conduction dans le substrat semi-conducteur.

10. Composant à semi-conducteur selon l'une des revendications 1 à 9,
dans lequel la connexion de la première zone dopée (3) se fait par le biais d'une zone fortement dopée du premier type de conduction dans le substrat semi-conducteur.

11. Procédé de fabrication pour un composant à semi-conducteur selon l'une des revendications 1 à 10, comprenant les étapes suivantes :
- production d'un diélectrique de grille (6) sur un substrat semi-conducteur (1) d'un second type de conduction ;
- application sur le diélectrique de grille (6) d'un masque photographique (11) qui est pourvu d'une ouverture dans la zone où doit être fabriqué un diélectrique de tunnel ;
- fabrication d'une première zone dopée (3) d'un premier type de conduction sous l'ouverture grâce à une implantation à travers le diélectrique de grille ;
- élimination du diélectrique de grille (6) de la surface de la première zone dopée (3) à l'exception d'une zone de bordure (3') de la première zone dopée ;
- élimination du masque photographique (11) présent ;
- production thermique d'un diélectrique de tunnel (7) sur la surface dégagée du substrat semi-conducteur et diffusion extérieure simultanée de la première zone dopée (3) sous le diélectrique de grille (6) ;
- fabrication d'une électrode de grille de tunnel (8a) sur le diélectrique de tunnel (7) et d'une électrode de grille de canal (8b) sur une partie prédéfinie du diélectrique de grille (6) ;
- fabrication d'une connexion pour la zone de canal (5) et d'une connexion pour le substrat semi-conducteur (1).

12. Procédé de fabrication selon la revendication 11, dans lequel le diélectrique de tunnel (7) est fabriqué de manière à être plus mince que le diélectrique de grille (6).

13. Procédé de fabrication selon l'une des revendications 11 à 12, dans lequel, lors de l'élimination du diélectrique de grille sur la première zone dopée (3), le reste de la surface du substrat est couvert par le masque photographique utilisé pour l'implantation de manière à ce que cette élimination soit ajustée automatiquement par rapport à la première zone dopée (3).
